Europäisches Patentamt

(19) European Patent Office

Office européen des brevets

(11) Publication number: **0 109 888**
A2

(12) # EUROPEAN PATENT APPLICATION

(21) Application number: 83402172.7

(22) Date of filing: 09.11.83

(51) Int. Cl.³: **H 01 L 29/90**

(30) Priority: 12.11.82 US 441028

(43) Date of publication of application:
30.05.84 Bulletin 84/22

(84) Designated Contracting States:
DE FR GB IT NL

(71) Applicant: FAIRCHILD CAMERA & INSTRUMENT
CORPORATION
464 Ellis Street
Mountain View California 94042(US)

(72) Inventor: Compton, James B.
19045 Skyline Boulevard
Los Gatos California 95030(US)

(74) Representative: Chareyron, Lucien et al,
Schlumberger Limited 42, rue Saint-Dominique
F-75340 Paris Cedex 07(FR)

(54) Subsurface Zener diode.

(57) A novel zener diode is formed which is suitable for use either as a discrete zener diode, or as one element of an integrated circuit device.

In one embodiment, a zener diode is fabricated utilizing an additional introduction of dopants in the zener diode, while forming other devices without this additional dopant introduction. Thus, the zener diode is formed having a large channel width, and therefore low series resistance and high parasitic JFET pinchoff voltage, while the remaining devices are formed having the desired current gains.

In another embodiment, the zener diode is fabricated wherein the PN junction of the zener diode located at portions near the surface of the device are specifically fabricated to have higher zener breakdown voltages than the zener breakdown voltage of the zener diode PN junction located beneath the surface of the zener diode, thereby providing improved zener diode characteristics as compared with certain zener diodes of the prior art where the zener breakdown occurs at the surface of the device.

FIG.6a

FIG.7

# SUBSURFACE ZENER DIODE

J. B. Compton

## BACKGROUND OF THE INVENTION

### Field of the Invention

This invention relates to semiconductor devices and more particularly for zener diodes for use either as discrete devices or in integrated circuits.

### Description of the Prior Art

Zener diodes are well known in the prior art and serve to provide a stable reference voltage and thus zener diodes must exhibit both short term (i.e. on the order of minutes) and long term (i.e. on the order of many hours) zener voltage stability, low zener noise (fluctuations in zener breakdown voltage from a nominal value), minimum series resistance and a highly reproducible zener breakdown voltage among a plurality of devices. When zener diodes are formed as one component within an integrated circuit, the zener diode must be fabricated in a manner which allows the zener breakdown voltage to be varied during fabrication without affecting other devices within the same integrated circuit, and which allows the zener diode to be fabricated with the same process as is used to form the other devices within the integrated circuit.

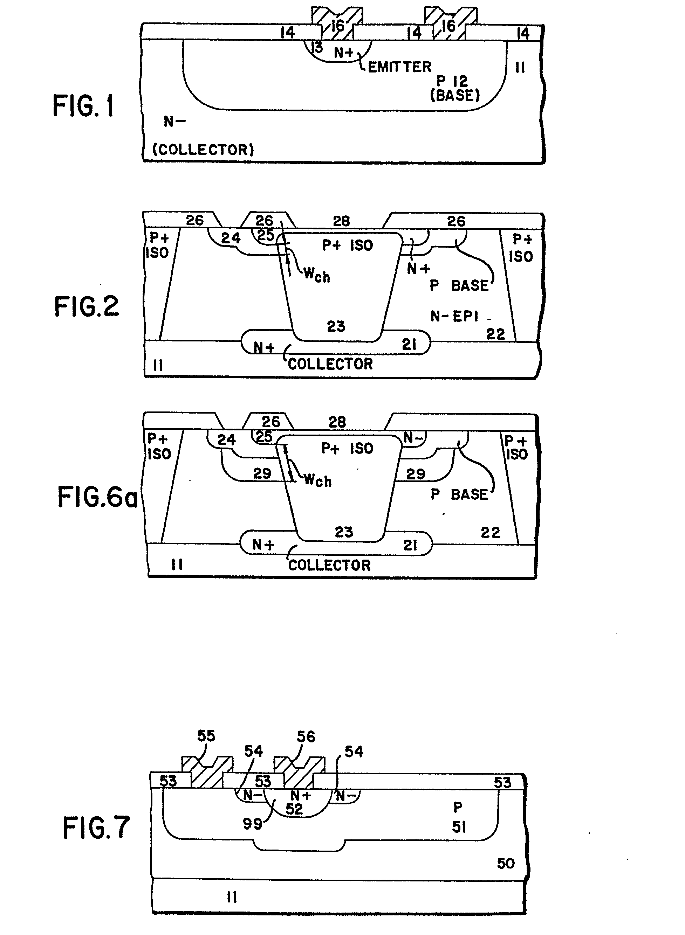

One such prior art zener diode is shown in the cross-sectional view of Figure 1, and is described, for example, in an article by Kennedy and O'Brien entitled "Avalanche Breakdown Characteristics of a Diffused P-N Junction", IRE Transactions on Electron Devices, November 1962, pages 478-483, which is hereby incorporated by reference. As shown in Figure 1, a transistor comprising N type collector region 11, P type base region 12, and N+ emitter region 13 is formed in a semiconductor substrate. Of importance, when this transistor is utilized as a zener diode, the collector 11 is not connected to a voltage potential, and the PN zener diode is formed by P type base 12 and N+ emitter 13. Such so-called emitter-base zener diodes are easily fabricated utilizing well known processes for fabricating bipolar transistors. Such emitter-base zener diodes are highly reproducible, thereby providing a substantially equal zener breakdown voltage in a plurality of devices, due to the high degree of control of dopant concentration in P type base region 12 which, in integrated circuits, is required to provide the desired sheet resistance for base regions of the bipolar transistors which are formed simultaneously with the formation of the emitter-base zener diode. However, the zener breakdown voltage of such emitter-base diodes is unstable, with drift in the zener breakdown voltage often greater than approximately 30 millivolts in the first few minutes of operation of the device. Furthermore, the zener noise of such emitter-base zener diodes is very high and not predictable, and the long term zener breakdown voltage stability is poor because the zener breakdown occurs in part at that point of the emitter 13-base 12 junction which is on the surface of the device (i.e., adjacent to oxide layer 14), where a rather high concentration of so-called "surface states" are present. Such surface states are described in the text by A.S. Grove entitled "Physics and Technology of Semiconductor Devices", John Wiley and Sons, Inc., 1967, which is hereby incorporated by reference.

Another prior art zener diode is a so-called "isolation emitter subsurface zener diode" shown in the cross-sectional view in Figure 2 and described in an article by Dobkin entitled "Monolithic Temperature Stabilized Voltage Reference with 0.5 ppm/° Drift", 1976 IEEE International Solid-State Circuits Conference, February 19, 1976, pages 108-109, which is hereby incorporated by reference. The isolation- emitter zener diode of Figure 2 includes P+ type isolation region 23 formed in N- epitaxial layer 22. Contact to the P+ isolation region 23 is made by means of P type base region 24. N+ emitter 25 is formed as shown, and the subsurface zener diode is formed at the junction of P+ isolation region 23 and N+ emitter region 25. Of importance, the entire junction between P+ isolation region 23 and N+ emitter region 25 is located beneath the surface 28 of the integrated circuit, thus providing substantially increased zener breakdown voltage stability as compared with the emitter-base zener diode of Figure 1. However, P+ isolation region 23 is typically rather large, thus providing a very large zener junction between P+ isolation region 23 and N+ emitter region 25, thus providing a very high zener diode noise level. Furthermore, in order to provide a highly controllable zener breakdown voltage, the dopant concentration of the P+ isolation region 23 must be tightly controlled. This is a distinct disadvantage when fabricating integrated circuits, because the dopant concentration of the P+ isolation region 23 is not generally tightly controlled because it is not necessary to do so when the P+ isolation region 23 is used solely for isolation and not for forming part of a zener diode. However, even with tight control of the isolation region 23 dopant concentration, the zener breakdown voltage between devices may vary by as much as one-half volt.

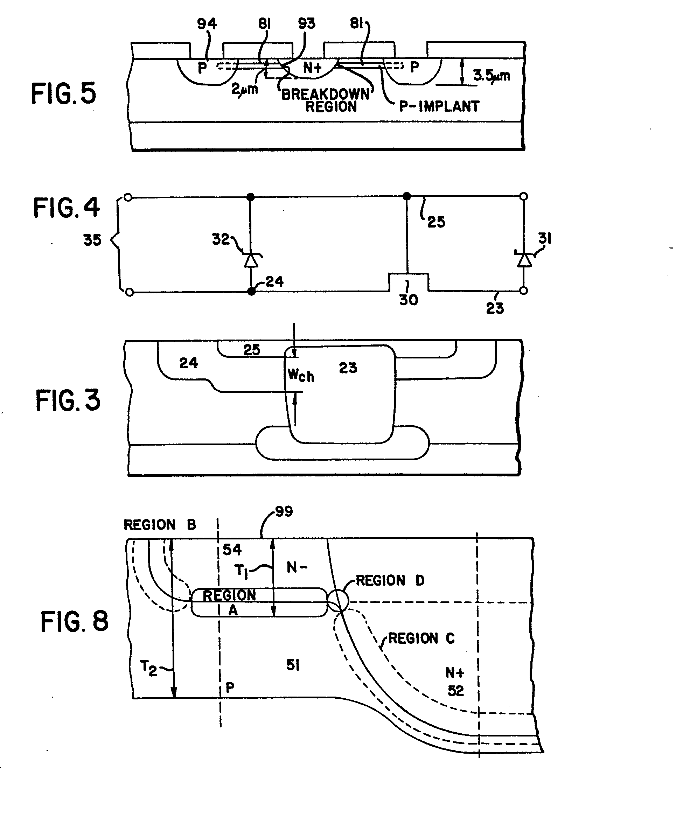

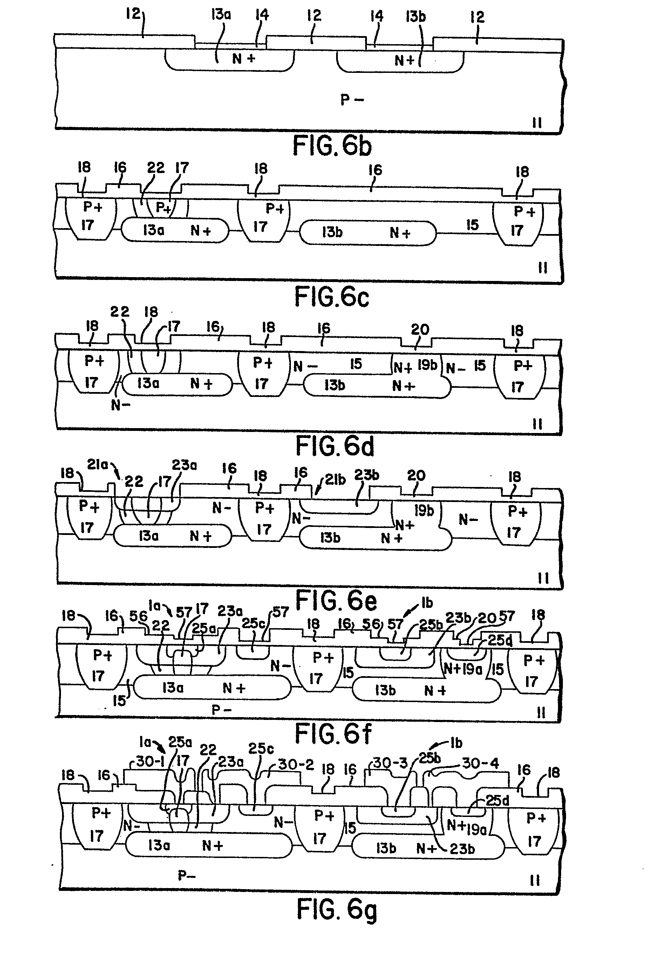

Furthermore, the P-type base region 24 which provides electrical connection to P+ isolation region 23 forms a parasitic P channel junction field effect transistor (JFET) as shown in Figures 3 and 4. As shown in the more detailed cross-sectional view of Figure 3 and the corresponding schematic diagram of Figure 4, P+ isolation region 23 forms the drain of JFET 30, N+ region 25 forms the gate of JFET 30, the portion of P region 24 located beneath N+ region 25 forms the channel of JFET 30, and the portion of P type region 24 which is electrically connected to other devices forms the source of JFET 30. As previously described, P+ isolation region 23 forms the anode of subsurface zener diode 31 and N+ emitter region 25 forms the cathode of subsurface zener diode 31. In a similar manner P region 24 forms the anode of the so-called surface zener diode 32, and N+ region 25 forms the cathode of the surface zener diode 32. Accordingly, the channel resistance of the JFET 30 is always connected in series with subsurface zener diode 31, thus providing an undesirably high series resistance. More importantly, however, is that if the pinchoff voltage of JFET 30 (i.e., that drain voltage above which JFET 30 turns off) is less than the zener breakdown voltage of the subsurface zener diode 31, JFET 30 will remain off and zener diode 31 will never receive the voltage to be clamped from terminals 35. In this case, only surface zener diode 32 will clamp the voltage on terminals 35. This clamping by surface zener diode is undesirable because surface zener diode 32 is susceptible to all of the disadvantages of the emitter-base zener diode previously described.

The pinchoff voltage of JFET 30 is defined as

$$V_P = KW^2_{ch}P_{ch} \qquad\qquad (1)$$

where    $V_p$ is the pinchoff voltage;
         $K$ is a constant;
         $W_{ch}$ is the channel width as shown in Figures 2 and 3; and
         $P_{ch}$ is the impurity concentration of the channel region 24.

In order to provide that the pinchoff voltage of JFET 30 is greater than the zener breakdown voltage of subsurface zener diode 31, the channel width $W_{ch}$ and/or the dopant concentration $P_{ch}$ of the channel 24 must be rather high. Because, in an integrated circuit, transistor devices (not shown) are formed simultaneously with the formation of the zener diode of Figure 2, with the base regions of the transistor devices being formed simultaneously with region 24 of Figure 2, a rather large channel width $W_{ch}$ and dopant concentration $P_{ch}$ of region 24 will provide a rather large base width and base region dopant concentration, thus providing an undesirable low current gain, or "beta", for transistors formed in the remainder of the integrated circuit.

Yet another prior art zener diode is described by Kwan in a research paper entitled "Ion-Implanted Sub-Surface Monolithic Zener Diode" submitted to the Department of Electrical Engineering and Computer Sciences, University of California, Berkeley, 1978, which is hereby incorporated by reference. The Kwan structure is shown in the cross-sectional view of Figure 5. The structure of Figure 5 provides a zener diode having extremely low zener noise due to the very low zener junction area, and highly reproducible and stable zener breakdown voltage. However, the Kwan structure of Figure 5 requires two diffusion steps, two masking steps, and two dopant implants in addition to the standard processing steps used to fabricate bipolar devices. Using this approach, the structure of Figure 5 is fabricated substantially independently from the process steps required to fabricate the bipolar devices (not shown) which are formed simultaneously in the remainder of the integrated circuit, thus resulting in a rather complex and expensive fabrication process. Furthermore, the structure of Figure 5 utilizes an ion implantation to form the interconnection region 81 between the zener junction 93 and the P type electrical contact 94, thus providing an undesirable high resistance in series with the zener diode, thus degrading the ability of the zener diode to clamp the voltage applied to the zener diode to a selected value over a wide range of current.

## SUMMARY

In accordance with the teachings of this invention, a novel zener diode is formed which is suitable for use either as a discrete zener diode, or as one element of an integrated circuit device.

In accordance with one embodiment of this invention, a zener diode is fabricated utilizing an additional introduction of dopants in the zener diode, while forming other devices without this additional dopant introduction. Thus, the zener diode is formed having a large channel width, and therefore low series resistance and high parasitic JFET pinchoff voltage, while the remaining devices are formed having the desired current gains.

In accordance with another embodiment of this invention, the zener diode is fabricated wherein the PN junction of the zener diode located at portions near the surface of the device are specifically fabricated to have higher zener breakdown voltages than the zener breakdown voltage of the zener diode PN junction located beneath the surface of the zener diode, thereby providing improved zener diode characteristics as compared with certain zener diodes of the prior art where the zener breakdown occurs at the surface of the device.

## BRIEF DESCRIPTION OF THE DRAWING

Figure 1 is a cross-sectional view of a prior art zener diode;

Figure 2 is a cross-sectional view of another prior art zener diode;

Figure 3 is a more detailed view of the prior art zener diode Figure 2;

Figure 4 is a schematic diagram of the structure of Figure 3;

Figure 5 is a cross-sectional view of yet another prior zener diode;

Figure 6a is a cross-sectional view of a zener diode constructed in accordance with one embodiment of this invention;

Figures 6b-6g depict one fabrication process used to construct the zener diode of Figure 6a;

Figure 7 is a cross-sectional view of a zener diode constructed in accordance with another embodiment of this invention;

Figure 8 is a more detailed cross-sectional view of a portion of a zener diode of Figure 7;

Figures 9a through 9g depict one fabrication process used to form one embodiment of the zener diode of this invention simultaneously with the formation of other semiconductor devices.

DETAILED DESCRIPTION

The cross-sectional view of Figure 6a shows one embodiment of a zener diode constructed in accordance with this invention. The presence of P type region 29, by increasing the channel width $W_{ch}$ to approximately 8 microns, as compared to the channel widths of prior art devices (typically 1 to 2 microns) raises the pinchoff voltage of the parasitic JFET (previously described in reference to Figure 4) to a value much in excess of the zener breakdown voltage, significantly reduces the effect of the parasitic JFET formed by regions 23, 24 and 25, while leaving unchanged the zener diode characteristics.

One technique for manufacturing the subsurface zener diode of Figure 6a and simultaneously fabricating bipolar transistors will be described in conjunction with figures 6b through 6g. As shown in Figure 6b, a P type silicon substrate 11 having a conductivity within the range of approximately 5 to 20 ohm-cm in a crystal orientation <111> is utilized. Oxide layer 12 is formed on the surface of substrate 11 to a thickness of approximately 1.3 microns, for example, by oxidation in wet oxygen at approximately 1100°C for approximately 60 minutes. Oxide layer 12 is then patterned, for example utilizing well known photolithographic and etching techniques, to define openings for the formation of N+ buried collector regions 13a and 13b. These openings within oxide layer 12 are formed, for example, by etching with buffered hydrofluoric acid. The N+ buried collector regions 13a, 13b are then formed, for example by first depositing either arsenic or antimony dopant to provide a sheet resistance of approximately 25 ohms/square, such as from an antimony trioxide ($Sb_2O_3$) source at approximately 1270°C for approximately 60 minutes. When antimony dopant is used, it is then diffused into substrate 11, for example, during the formation of oxide layer 14. The formation of oxide layer 14 and the diffusion of the antimony dopant are performed, for example, by subjecting substrate 11 to dry oxygen at approximately 1270°C for approximately 360 minutes, thus forming oxide 14 to a thickness of approximately 4000 angstroms. The thickness of oxide 12 is increased somewhat during this step, although this is unimportant. Buried collector region 13a will serve as the anode of the to-be-formed zener diode 1a, and buried collector region 13b will serve as the collector of the to-be-formed NPN transistor 1b.

Oxide layers 12 and 14 are then removed, for example, by etching with hydroflouric acid. A layer of N type epitaxial silicon 15 is then formed on P- substrate 11, as shown in Figure 6c. This layer of epitaxial silicon 15 is formed to a thickness of approximately 18 microns, for example by using $SiCl_4$ at approximately 1150°C for a sufficient time to provide the desired thickness of epitaxial silicon 15. Epitaxial silicon 15 has a dopant concentration within the range of approximately $1 \times 10^{14}$ to $5 \times 10^{15}$ atoms/cm$^3$ and a conductivity within the range of approximately 1 to 5 ohm-cm.  The combination of substrate 11 and epitaxial silicon layer 15 will hereinafter be referred to as a "wafer."

Referring to Figure 6c, a layer of oxide 16 is then formed on the surface of epitaxial silicon 15.  Oxide 16 is formed to a thickness of approximately 13,000 angstroms, for example, by oxidation in wet oxygen at approximately 1100°C for approximately 120 minutes.  Oxide layer 16 is then patterned, for example utilizing well known photolithographic and etching techniques to define the locations of P+ isolation regions 17.  Exposed portions of oxide layer 16 are etched, for example, with buffered hydrofluoric acid, thereby exposing the regions within epitaxial silicon layer 15 in which P+ isolation regions 17 are to be formed.  As shown in Figure 6c, P+ isolation regions 17 are then formed, for example by introducing boron dopant into the exposed regions of epitaxial silicon 15 to provide a sheet resistance of approximately 6 ohms/square, for example, by utilizing a $B_2O_3$ source at approximately 1100°C for approximately 30 minutes.  After this boron deposition into regions 17, the wafer is again masked to open an additional region 22 around that portion of region 17 which is to form the zener diode.  The wafer is again introduced to a second boron deposition of higher sheet resistance, for example, using a BN source at approximately 965°C for approximately 20 minutes to give a sheet resistance of approximately 50 ohms/square.  The boron dopant which has been deposited through the openings of oxide 16 into the to be formed P+ isolation regions 17 and into the to be formed region 22 is then diffused, for example during the formation of oxide layer 18.  Oxide layer 18 is formed and the boron dopant is diffused, for example, by subjecting the wafer to dry oxygen at approximately 1200°C for approximately 4 hours, thus forming oxide layer 18 to a thickness of approximately 6000 anstroms, and diffusing the P+ dopants to form P+ isolation regions 17 and region 22 as

shown in Figure 6c. During the formation of oxide 18, the thickness of oxide layer 16 is increased slightly, although this is unimportant.

As shown in Figure 6d, N+ contact 19b is formed to provide electrical connection to N+ buried collector region 13b. To form N+ contact region 19b, oxide layer 16 is patterned, for example utilizing well known photolithographic techniques, in order to define the locations of N+ contact region 19b. The exposed portions of oxide layer 16 are then etched, for example with buffered hydrofluoric acid, thereby exposing the surface of epitaxial silicon layer 15 in the location of the to be formed N+ contact region 19b. N type dopants are then deposited in the exposed regions of epitaxial layer 15. This deposition is performed, for example, by the introduction of phosphorus dopant to provide a V/I characteristic of approximately 2.2 such as by using a $POCl_3$ source at approximately 1100°C for approximately 1 hour. The N type dopant is then diffused, for example, by subjecting the wafer to dry oxygen at approximately 1200°C for approximately 180 minutes, thereby diffusing the N+ dopant to form N+ contact 19b which makes contact with N+ buried collector region 13b. During this diffusion, oxide layer 20 is formed to a thickness of approximately 3000 angstroms. During this formation of oxide layer 20, oxide layers 16 and 18 are also increased slightly in thickness, although this is unimportant. Of importance, N+ contact region 19b needs only be formed if it is desired to reduce the saturation resistance of the transistors or other diodes formed simultaneously with the zener diode formed in accordance with this invention.

As shown in Figure 6e, oxide layers 16 and 18 are then patterned to form openings 21a and 21b for the formation of P type zener diode region 23a which overlaps region 22 previously formed, and P type transistor base 23b, respectively. In this step, oxide layers 16 and 18 are patterned, for example, by using well known photolithographic techniques, and the exposed portions of oxide layer 16 are removed, for example by etching with buffered hydrofluoric acid. P type dopants are then introduced into the exposed portions of epitaxial silicon layer 15, for example by exposing the surface of the wafer to a BN source at approximately 900-1000°C for approximately 35 minutes, thereby introducing dopants into the exposed portions of epitaxial layer 15 to provide a sheet resistance within the range of approximately 40 to 60 ohms/square. These P type dopants are then diffused, for example by exposing the wafer to wet oxygen at approximately 1150°C for approximately 90 minutes, thereby forming an oxide layer 56 (Figure 6f) over the P type regions 23a,      and 23b to a thickness of approximately 5000 angstroms. The thickness of oxide regions 16, 18, and 20 are increased slightly during this step, although this slight increase in thickness is unimportant.

Referring now to Figure 6f, the locations of N+ regions 25a, 25b, 25c and 25d are now defined, for example by utilizing well known photolithographic techniques. The exposed portions of oxide layer 56 are then removed, for example by etching with buffered hydrofluoric acid, thereby exposing those portions of epitaxial silicon layer 15 where N+ regions 25a through 25d are to be formed. N+ regions 25a through 25d are then formed, for example by depositing phosphorus dopant to provide a V/I characteristic within the range of approximately 4 to 6 ohms/square into the exposed portions of epitaxial silicon layer 15 for example, by using a $POCl_3$ source at approximately 1020°C. These phosphorus dopants are then diffused to form N+ regions 25a through 25d, for example, by subjecting the wafer to wet oxygen at approximately 1070°C for approximately 30 minutes, thereby forming oxide layers 57 to a thickness of approximately 2200 anstroms. The thicknesses of oxide layer 16, 18, 20, and 56 are also increased slightly during this time, although this slight increase in thickness is unimportant. Region 25a serves as the cathode of the zener diode 1a and must overlap the diffused edge of region 17. Region 25b serves as the emitter of NPN transistor 1b. Region 25c serves as a contact to collector region 13a and region 25d serves as a contact to collector region 13b.

As shown in Figure 6g, electrical interconnects 30-1 through 30-4 are then formed, if desired. These electrical interconnects are formed by first patterning the oxide layers 16, 18, 20, 56 and 57 to expose those regions formed within epitaxial silicon layer 15 which are to be connected to electrical interconnects 30-1 through 30-4. This definition of oxide layers 16, 18, 20, 56 and 57 is performed, for example, by well known photolithographic techniques and etching the exposed portions of the oxide layers with buffered hydro fluoric acid. With the selected regions formed within epitaxial silicon layer 15 exposed by the removal of appropriate portions of the oxide layer, a layer of electrically conductive material, such as aluminum, an alloy of aluminum, or doped polycrystalline silicon, is then formed on the surface of the wafer in a well known manner and patterned utilizing well known photolithographic etching techniques in order to form the plurality of electrical interconnects 30-1 through 30-4. The completed structure is thus shown in figure 6g.

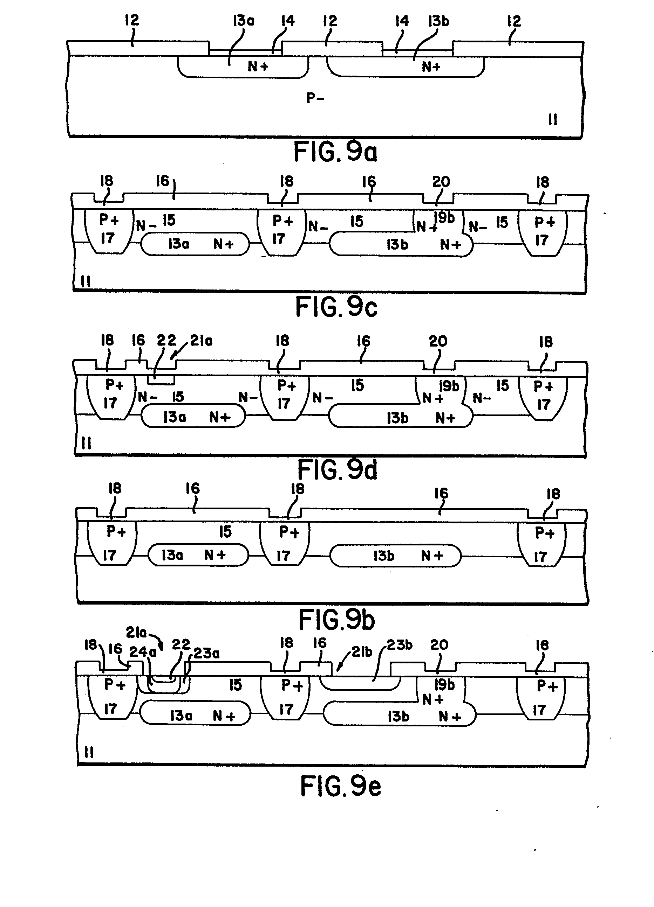

A cross-sectional view of another embodiment of this invention is shown in Figure 7. Formed on silicon substrate 11 is N type epitaxial silicon layer 50. Within N type epitaxial region 50 is formed P type region 51 which forms the anode of the zener diode constructed in accordance with this embodiment of my invention. Formed within P type region 51 is N+ region 52, which forms the cathode of the zener diode. N type region 54 is formed as shown within P type region 51. The surface of the substrate is covered with an insulation layer 53 through which openings are formed and electrical contacts 55 and 56 are formed to provide electrical interconnection to P type region 51 and N+ region 52, respectively. An expanded view of a portion of the structure of Figure 7 is shown in the cross-sectional view of Figure 8, with corresponding regions labeled with corresponding numbers.

The zener breakdown voltage of region A of the structure of Figure 8 is the plane junction breakdown voltage of the junction between N type region 54 and P type region 51. For the PN junction of region A, which may be considered to be a symmetrical step junction since the dopant concentrations are substantially equal (although of opposite conductivity types) on each side of the junction, the avalanche electrical field (i.e., the electric field required to cause avalanche across a PN junction) is about $2.5 \times 10^5$ volts/cm. The zener breakdown voltage of region A is defined by the following equation:

$$V = E_a^2 E_{Si}/(qN) = 9.77 \text{ volts};$$

where: $N$ = the concentration of donor atoms or acceptor atoms = $4 \times 10^{18}$ atoms/$cm^3$;

$E_{Si}$ = the dielectric constant of silicon
= $10^{-12}$ farads/cm;

$E_a$ = the critical electric field at breakdown;

$q$ = the magnitude of the charge of an electron
= $1.6 \times 10^{-19}$ coulomb; and

$V$ = the zener breakdown voltage of region A.

The zener breakdown voltage of the PN junction of region B of Figure 8 is dependent on the radius of curvature of the PN junction of region B. In order for the radius of curvature of the PN junction to have a significant effect on the zener breakdown voltage, the radius of curvature of the junction must be less than the width of the depletion layer during avalanche. The depletion width ($W_d$) is defined as:

$$W_d = f(N_A, N_D, E_a)$$

where:

$N_A$ = The concentration of acceptor atoms; and
$N_D$ = The concentration of donor atoms.

Accordingly, it has been found that if the PN junction of region B is located in excess of approximately 0.2 microns from the surface 99 of the device, the radius of curvature of the PN junction of region B will not significantly reduce the zener breakdown voltage of the PN junction of region B below the zener breakdown voltage of the PN junction of region A. This is desirable in order to eliminate the effects of the surface zener diode formed in region B.

The zener breakdown voltage of the PN junction of region C is merely the subsurface zener breakdown voltage of the emitter-base junction of conventional PN diodes. For the PN junction of region C, the zener breakdown voltage is typically on the order of approximately 6 volts.

The zener breakdown voltage of the PN junction of region B is substantially higher than that of regions C and D since the dopant concentration of region 54 is much less than the dopant concentration of region 52. Region D will have a higher zener breakdown voltage than region C because the dopant concentration of region 51 within region D is lower than the dopant concentration of region 51 within region C due to the resultant dopant redistribution effects caused by the curvature of the PN junction within region D. The portion of region C nearest region D thus has the highest dopant concentration of both regions 51 and 52, and thus the portion of region C nearest region D has the lowest zener breakdown voltage of regions A, B, C and D.

The PN junctions of regions A, B, C and D act together in order that the zener breakdown voltage of the device as a whole will be dominated by that portion of region C nearest region D, because all other regions have higher breakdown voltages than this portion of region C.

Accordingly, the dopant requirements necessary to fabricate a zener diode in accordance with this embodiment of my invention are as follows. First, the dopant concentration of N type region 54 must be at least slightly greater than the dopant concentration of P type region 51 at surface 99, in order to provide within region 54 a greater concentration of N type impurities than P type impurities, thereby causing region 54 to be a lightly doped N type region. Secondly, the dopant concentration of N type region 54 must be lower (at least by a factor of ten and preferably by a factor of one hundred) than the dopant concentration of N+ region 52 at surface 99 in order to provide an N type dopant concentration of region 54 within region A which is substantially equal to the P type dopant concentration of region 54 within regions A and B, thus causing regions A and B to act as symmetrical junctions having higher zener breakdown voltages than zener breakdown voltage of regions C and D. The thickness $T_1$ of N type region 54 is preferably much less than the thickness $T_2$ of P type region 51 in order to minimize the series resistance of P type region 51. Preferably, the thickness of region 54 at most is ten percent of the thickness of region 51. Finally, the thickness $T_1$ of N type region 54 must be much greater (preferably by at least a factor of ten) than the width of the depletion region (not shown) during zener breakdown. The depletion region width during zener breakdown is approximately $0.01\mu$, with the depletion region width being greater on a curved junction (e.g. within regions B and D) due to electric field "crowding" than along the substantially straight junction of region A.

With the thickness of region 54 greater than the width of the depletion region during zener breakdown, the curvature of the PN junction within region B has little effect on the zener breakdown voltage of region B, thereby maintaining the zener breakdown voltage of region B greater than the zener breakdown voltage of region D, thus preventing zener breakdown from occurring within region B.

It is also desirable, although not necessary, that the dopant concentration gradient between N type region 54 and P region 51 be less (by at least a factor of 10 and preferably by a factor of 100) than the dopant concentration gradient between P type region 51 and N+ region 52, in order to insure that the zener breakdown voltages of regions A and B are greater than the zener breakdown voltage of region D.

The zener noise of a zener diode constructed in accordance with this embodiment of my invention is similar to the zener noise of the Kwan structure (previously described) due to the small area in which zener breakdown occurs (i.e., the small portion of region C nearest region D). In addition, the contribution to the zener noise due to series resistance is lower than in the Kwan structure due to the lower resistance of region 51 (Figure 8) as compared with Kwan's region 81 (Figure 5). .

One technique for manufacturing the subsurface zener diode constructed in accordance with this invention and simultaneously fabricating bipolar transistors will be described in conjunction with figures 9a through 9g. As shown in Figure 9a, a P type silicon substrate 11 having a conductivity within the range of approximately 5 to 20 ohm-cm and a crystal orientation <111> is utilized. Oxide layer 12 is formed on the surface of substrate 11 to a thickness of approximately 1.3 microns, for example, by oxidation in wet oxygen at approximately 1100°C for approximately 60 minutes. Oxide layer 12 is then patterned, for example utilizing well known photolithographic and etching techniques, to define openings for the formation of N+ buried collector regions 13a and 13b. These openings within oxide layer 12 are formed, for example, by etching with buffered hydrofluoric acid. The N+ buried collector regions 13a, 13b are then formed, for example, by first depositing either arsenic or antimony dopant to provide a sheet resistance of approximately 25 ohms/square, such as from an antimony trioxide ($Sb_2O_3$) source at approximately 1270°C for approximately 60 minutes. When antimony dopant is used, it is then diffused into substrate 11, for example, during the formation of oxide layer 14. Oxide layer 14 and the diffusion of the antimony dopant is performed, for example, by subjecting substrate 11 to dry oxygen at approximately 1270°C for approximately 360 minutes, thus forming oxide 14 to a thickness of approximately 4000 angstroms. The thickness of oxide 12 is increased somewhat during this step, although this is unimportant. Buried collector region 13a will serve as the anode of the to-be-formed zener diode 1a, and buried collector region 13b will serve as the collector of the to-be-formed NPN transistor 1b.

Oxide layers 12 and 14 are then removed, for example, by etching with hydrofluoric acid. A layer of N type epitaxial silicon 15 is then formed on substrate 11, as shown in Figure 9b. This layer of epitaxial silicon 15 is formed to a thickness of approximately 18 microns, for example by using $SiCl_4$ at approximately 1150°C for a sufficient time to provide the desired thickness of epitaxial silicon 15. Epitaxial silicon 15 has a dopant concentration within the range of approximately $1 \times 10^{14}$ to $5 \times 10^{15}$ atoms/cm$^3$ and a conductivity within the range of approximately 1 to 5 ohm-cm. The combination of substrate 11 and epitaxial silicon layer 15 will hereinafter be referred to as a "wafer."

A layer of oxide 16 is then formed on the surface of epitaxial silicon 15. Oxide 16 is formed to a thickness of approximately 13,000 angstroms, for example, by oxidation in wet oxygen at approximately 1100°C for approximately 120 minutes. Oxide layer 16 is then patterned, for example utilizing well known photolithographic and etching techniques to define the locations of P+ isolation regions 17. Portions of oxide layer 16 are etched, for example, with buffered hydrofluoric acid to expose the regions within epitaxial silicon layer 15 in which P+ isolation regions 17 are to be formed. P+ isolation regions 17 are then formed, for example by introducing boron dopant into the exposed regions of epitaxial silicon 15 to provide a sheet resistance of approximately 6 ohms/square, for example, by utilizing a $B_2O_3$ source at approximately 1100°C for approximately 30 minutes. The boron dopant which is deposited through the openings of oxide 16 into the to be formed P+ isolation regions 17 is then diffused, for example during the formation of oxide layer 18. Oxide layer 18 is formed and the P+ isolation dopant is diffused, for example, by subjecting the wafer to dry oxygen at approximately 1200°C for approximately 4 hours, thus forming oxide layer 18 to a thickness of approximately 6000 anstroms, and diffusing the P+ dopants to form P+ isolation regions 17 as shown in Figure 9b. During the formation of oxide 18, the thickness of oxide layer 16 is increased slightly, although this is unimportant.

As shown in Figure 9c, N+ contact 19b is formed to provide electrical connection to N+ buried collector region 13b. To form N+ contact region 19b, oxide layer 16 is patterned, for example, utilizing well known photolithographic techniques, in order to define the locations of N+ contact region 19b. The exposed portion of oxide layer 16 is then removed, for example, by etching with buffered hydrofluoric acid, thereby exposing the surface of epitaxial silicon layer 15 in the location of the to be formed N+ contact region 19b. N type dopants are then deposited in the exposed regions of epitaxial layer 15. This deposition is performed, for example, by the introduction of phosphorus dopant to provide a V/I caracteristic of approximately 2.2 such as by using a $POCl_3$ source at approximately 1100°C for approximately 1 hour. The N type dopant is then diffused, for example, by subjecting the wafer to dry oxygen at approximately 1200°C for approximately 180 minutes, thereby diffusing the N+ dopant to form N+ contact 19b which makes contact with N+ buried collector region 13b. During this diffusion, oxide layer 20 is formed to a thickness of approximately 3000 angstroms. During this formation of oxide layer 20, oxide layers 16 and 18 are also increased slightly in thickness, although this is unimportant. Of importance, N+ contact region 19b need only be formed if it is desired to reduce the saturation resistance of the transistors or other diodes formed simultaneously with the zener diode formed in accordance with this invention.

0109888

As shown in Figure 9d, the location 21a where the zener diode is to be formed is then defined, for example, by well known photolithographic techniques. The exposed portion of oxide layer 16 which indicates where the zener diode is to be formed is removed, for example, by etching with buffered hydrofluoric acid. An N type region 22 is then formed, for example, by the ion implantation of arsenic into reexposed portion of epitaxial layer 15. This arsenic implant is performed, for example, by well known ion implantation techniques utilizing an energy level of approximately 150 KEV to a dosage within the range of approximately $2x10^{14}$ to $10x10^{14}$ atoms/$cm^2$. This dosage is adjusted to optimize the zener diode character-istics in accordance with the dopant concentration of the to-be-formed P type region 23a (Fig. 9e). During this ion implantation, oxide layers 16, 18, and 20 serve as a mask, thereby preventing the implantation of arsenic into regions other than region 22 where the oxide layer 16 has been removed.

As shown in Figure 9e, oxide layer 16 is then patterned to form openings 21a and 21b for the formation of P type zener diode region 23a and P type transistor base 23b, respectively. In this step, oxide layer 16 is patterned, for example, by using well known photolithographic techniques, and the exposed portions of oxide layer 16 are removed, for example by etching with buffered hydrofluoric acid. P type dopants are then deposited in the exposed portions of epitaxial layer 15, for example by exposing the surface of the wafer to a BN source at approximately 900-1000°C for approximately 35 minutes, thereby introducing dopants into the exposed portions of epitaxial layer 15 to provide a sheet resistance within the range of approximately 40 to 60 ohms/square. These P type dopants are then diffused, for example by exposing the wafer to wet oxygen at approximately 1150°C for approximately 90 minutes, thereby forming an oxide layer 56 (Figure 9f) over the P type regions 23a and 23b to a thickness of approximately 5000 angstroms. The thickness of oxide regions 16, 18, and 20 are increased slightly during this step, although this slight increase in thickness is unimportant.

If it is desired to modify the zener breakdown voltage from the value which will be provided by the dopants and concentration given by the above described process steps, without affecting the operation of other transistors and diodes being formed simultaneously with the formation of the zener diodes, a masking step to expose only that portion of epitaxial silicon layer 15 where region 24a is to be formed (i.e., and not region 23b) is utilized, and an additional dopant implantation used which, after diffusion, provides region 24a (Figures 9e-9g). If such additional implant is made with a P type dopant (such as boron), the zener voltage will be reduced while if it is made with an N type dopant (such as phosphorus), the zener voltage will be increased. Such adjustment of the zener breakdown voltage is capable of providing an adjustment of approximately ± 30% of the nominal zener voltage of zener diodes.

Referring now to Figure 9f, the locations of N+ regions 25a through 25d are now defined, for example by utilizing well known photolithographic techniques. The exposed portions of oxide layers 56, 16 and 20 then removed, for example by etching with buffered hydrofluoric acid, thereby exposing those portions of epitaxial silicon layer 15 where N+ regions 25a through 25d are to be formed. N+ regions 25a through 25d are then formed, for example by depositing phosphorus dopant to provide a V/I characteristic within the range of approximately 4 to 6 ohms/square into the exposed portions of epitaxial silicon layer 15, for example, by using a $POCl_3$ source at approximately 1020°C. These phosphorus dopants are then diffused to form N+ regions 25a through 25d for example, by subjecting the wafer to wet oxygen at approximately 1070°C for approximately 30 minutes, thereby forming oxide layer 57 to a thickness of approximately 2200 anstroms. The thicknesses of oxide layer 16, 18, 20, and 56 are also increased slightly during this time, although this slight increase in thickness is unimportant. Region 25a serves as the cathode of the zener diode 1a, and region 25b serves as the emitter of NPN transistor 1b. Region 25c serves as a collector contact to collector region 13a and region 25d serves as a collector contact to collector region 13b.

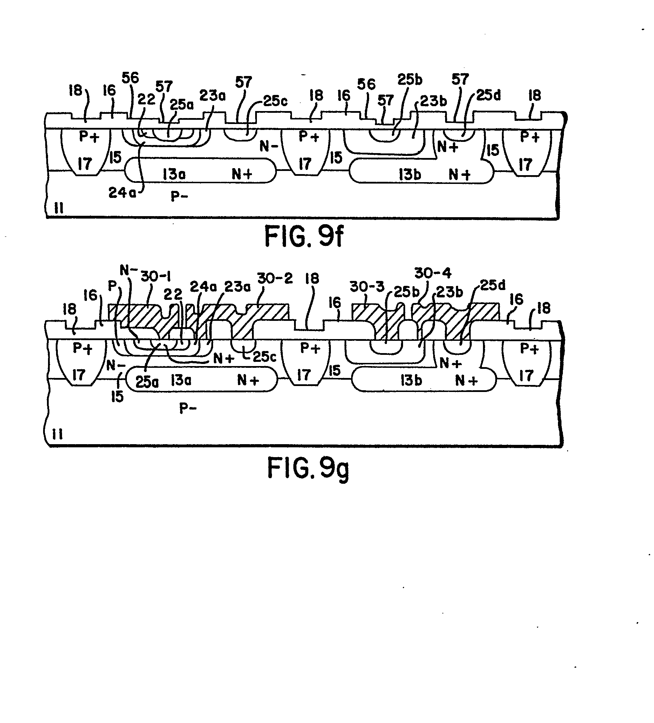

As shown in Figure 9g, electrical interconnects 30-1 through 30-4 are then formed, if desired. These electrical interconnects are formed by first patterning the oxide layers 16, 18, 56 and 57 to expose those regions formed within epitaxial silicon layer 15 which are to be connected to electrical interconnects 30-1 through 30-4. This definition of oxide layers 16, 18, 56 and 57 is performed, for example, by well known photolithographic techniques and etching the oxide layers with buffered hydrofluoric acid. With the selected regions formed within epitaxial silicon layer 15 exposed by the removal of appropriate portions of the oxide layer, a layer of electrically conductive material, such as aluminum, an alloy of aluminum, or doped polycrystalline silicon, is then formed on the surface of the wafer and patterned utilizing well known photolithographic etching techniques in order to form the plurality of electrical interconnects 30-1 through 30-4. The completed structure is thus shown in figure 9g .

While specific embodiments of this invention have been described in the specification, the description of these specific embodiments is intended to serve by way of example only, and is not to be construed as limitation of the scope of my invention. Numerous other embodiments of my invention will become readily apparent to those of ordinary skill in the art in light of the teachings of the specification.

CLAIMS

1. A zener diode comprising:

a first semiconductor region of a first conductivity type having a top surface;

a second semiconductor region of a second conductivity type opposite said first conductivity type formed within said first region; and

a third semiconductor region of said first conductivity type formed within said second semiconductor region; and characterized by

a fourth semiconductor region of said first conductivity type formed within said second semiconductor region so as to surround said third semiconductor region, said fourth semiconductor region being formed within said second semiconductor region to a lesser depth than said third semiconductor region; and

characterized in that the zener breakdown voltage of the junction between said second and said third semiconductor regions is less than the zener breakdown voltage of the junction between said second and said fourth semiconductor regions.

2. The structure as in claim 1 characterized in that said first semiconductor region comprises an epitaxial silicon layer formed on a semiconductor substrate of said second conductivity type and characterized by a buried region of said first conductivity type formed within said substrate.

3. The structure either in claim 1 or claim 2 characterized in that the dopant concentration of said fourth region is less than the dopant concentration of said third region at said top surface of said first semiconductor region.

4. The structure as in claim 3 characterized in that said dopant concentration of said fourth region is less than said dopant concentration of said third region at said top surface of said first semiconductor region by at least a factor of ten.

0109888

- 24 -

5. The structure as in claim 4 characterized in that the dopant concentration gradient between said second region and said fourth region is less than the dopant concentration gradient between said second region and said third region.

6. The structure as in claim 5 characterized in that said dopant concentration gradient between said second region and said fourth region is less than said dopant concentration gradient between said second region and said third region by at least a factor of ten.

7. The structure as in any one of claim 1 - 6 characterized in that the thickness of said fourth region is approximately 10 percent of the thickness of said second region.

8. The structure as in any one of claims 1 - 7 characterized in that the thickness of said fourth region is greater than the width of the depletion layer surrounding the junction formed between said second and fourth regions during zener breakdown.

9. The structure as in any one of claims 1 - 8 characterized by a fifth semiconductor region formed within said first semiconductor region, said fifth region being surrounded by said second semiconductor region and formed to approximately the same thickness as said second semiconductor region.

10. A method for forming a zener diode characterized by the steps of:
    forming within a first semiconductor region of a first conductivity type a second region of said first conductivity type;
    forming within said first semiconductor region a third region of a second conductivity type opposite said first conductivity type, said third region being formed such that said second region is contained within said third region; and

forming a fourth region of said first conductivity type within said second region such that the depth of said fourth region is greater than the depth of said second region and less than the depth of said third region.

11. The method as in claim 10 characterized by the step of forming a fifth region which is surrounded by said third region and formed to approximately the same thickness as said third region.

12. The method as in either claim 10 or claim 11 characterized by the steps of forming said first region as an epitaxial silicon layer formed on a silicon substrate of said first conductivity type and forming a buried collector region in said substrate, and characterized in that said second and third regions are formed to a depth sufficient to contact said buried collector region.

13. A zener diode comprising:

a first semiconductor region of a first thickness of a first conductivity type having a top surface;

a second semiconductor region of a second conductivity type opposite said first conductivity type formed to a second thickness within said first region and entirely beneath said top surface;

a third semiconductor region of said second conductivity type formed within said first semiconductor region to a third thickness less than said second thickness and adjacent to said top surface; and

a fourth semiconductor region of said first conductivity type formed within said third semiconductor region and adjacent to said top surface to a fourth thickness less than said second thickness; and characterized by

a fifth semiconductor region of said second conductivity type formed within said first region and adjacent to said second and third regions; and

characterized in that the pinchoff voltage of the parasitic JFET with drain formed by said second region, gate formed by said fourth region, channel formed by the portions of said third region and said fifth region beneath said fourth region, and source formed by the portion of said third region adjacent said top surface, is substantially greater than the zener breakdown voltage of the junction between said second and fourth semiconductor regions.

14. The structure as in claim 13 characterized in that said first semiconductor region comprises an epitaxial silicon layer formed on a semiconductor substrate of said second conductivity type and characterized by a buried region of said first conductivity type formed within said substrate, said buried region contacting said second semiconductor region.

15. A method for forming a zener diode characterized by the steps of:

forming within a first semiconductor region of a first conductivity type a second region of a second conductivity type opposite said first conductivity type;

forming within said first semiconductor region a third region of said second conductivity type, said third region being formed such that said second region is contained within said third region;

forming a fourth region of said second conductivity type within said first region such that the depth of said fourth region is less than the depth of said third region; and

forming a fifth region of said first conductivity type within said third region, said fifth region being formed to a depth less than the depth of said second region, and said fifth region being formed to a width greater than the width of said second region.

16. The method as in claim 15 characterized by the steps of forming said first region as an epitaxial silicon layer formed on a silicon substrate of said first conductivity type and forming a buried collector region in said substrate, characterized in that said second and third regions are formed to a depth sufficient to contact said buried collector region.

0109888

1/5

FIG.1

FIG.2

FIG.6a

FIG.7

0109888

2/5

FIG.5

FIG.4

FIG.3

FIG.8

3/5

FIG.6b

FIG.6c

FIG.6d

FIG.6e

FIG.6f

FIG. 6g

0109888

FIG. 9a

FIG. 9c

FIG. 9d

FIG. 9b

FIG. 9e

5/5

FIG. 9f

FIG. 9g